# EUROPÄISCHE PATENTSCHRIFT

(11) **EP 1 381 115 B1**
(45) Veröffentlichungstag und Bekanntmachung des Hinweises auf die Patenterteilung: **23.06.2004**
(21) Anmeldenummer: 03011570.3
(22) Anmeldetag: 22.05.2003
(51) Int. Cl.: H01R 9/26, H01H 1/42

(54) **Druckkontaktiertes Leistungshalbleiterrelais**
Pressure contact power semiconductor relay
Relais semi-conducteur de puissance à contact de pression

(30) Priorität: 11.07.2002 DE 10231219
(43) Veröffentlichungstag der Anmeldung: 14.01.2004
(73) Patentinhaber: Semikron Elektronik GmbH Patentabteilung, 90253 Nürnberg (DE)
(72) Erfinder: Bellu, Roberto, 09010 S. Giovanni Suergiu (CA) (IT); Salvati, Paolo, 00100 Roma (RM) (IT); Sterpone, Benito, 00041 Albano Laziale (RM) (IT)

(56) Entgegenhaltungen:
- EP-A- 0 895 446
- DE-U- 29 723 167
- US-A- 5 099 396
- US-A1- 2001 025 964

## Beschreibung

Die Erfindung beschreibt den Aufbau eines Halbleiterrelais wie es als leistungsfähige und kostengünstige Alternative zu elektro- mechanischen Bauelementen vielfach beschriebener Stand der Technik ist. Halbleiterrelais dienen dem mittels eines Steueranschlusses definierten Schalten einer Wechselstromlast. Der prinzipielle Aufbau derartiger Halbleiterrelais aus antiparallel geschalteten Halbleiterschaltern ist seit langem bekannt.

Der interne Aufbau eines Halbleiterrelais ist beispielhaft aus der DE 43 13 882 C1 bekannt. Der mechanische Aufbau nach dem Stand der Technik weist ein Substrat, meist mit Grundplatte auf. Auf diesem Substrat sind die Halbleiterschalter schaltungsgerecht angeordnet und verbunden. Weiterhin weisen Halbleiterrelais nach dem Stand der Technik eine Steuereinrichtung zur Ansteuerung der Halbleiterschalter auf. Die Steuereinrichtung sowie das Substrat bzw. die darauf befindlichen Halbleiterschalter sind mittels gelöteter starrer Verbindungen miteinander verschaltet. Die Kontaktelemente zum Anschluss der zu schaltenden externen Stromleiter sind ebenfalls über starre gelötete Verbindungselemente mit dem Substrat bzw. den Halbleiterschaltern verbunden.

Nachteilig am Stand der Technik ist, dass der Fertigungsprozess eine Mehrzahl von einzelnen Lötprozessen starrer Verbindungen einschließt und somit der gesamte Aufbau einer rationellen Fertigung nicht leicht zugänglich ist. Nachteilig ist weiterhin, dass gelötete Kontakte mit starren Verbindungen in ihrer Dauerhaltbarkeit eingeschränkt sind, speziell bei einer Vielzahl von Temperaturwechseln.

Die vorliegende Erfindung hat die Aufgabe, ein Halbleiterrelais bestehend aus einem Substrat mit darauf angeordneten Halbleiterbauelementen, einem Gehäuse sowie Anschlusselementen und Kontaktelementen vorzustellen, wobei die starren löttechnischen Verbindungen zu den Anschlusselementen durch dauerhaft haltbare Alternativen ersetzt werden, die eine über die Lebensdauer sichere elektrische Kontaktierung sowie eine sicher thermische Kontaktierung mit einem Grund- oder Kühlkörper gestattet und welches einem einfachen, automatisierbaren Herstellungsverfahren zugänglich ist.

Die Aufgabe wird gelöst durch die Maßnahmen des Anspruchs 1. Weitere vorteilhafte Ausgestaltungen sind in den Unteransprüchen genannt.

Der Grundgedanke der Erfindung ist ein mit einem Grund- oder Kühlkörper druckkontaktiertes Halbleiterrelais ohne Grundplatte vorzustellen, bestehend aus einem keramischen Substrat (10), einem mehrteiligen Gehäuse und darin angeordneten Anschluss- und Kontaktelementen und einer Steuereinrichtung zur Ansteuerung der Halbleiterbauelemente.

Das Substrat besteht aus einem keramischen Grundkörper mit einer strukturierten metallkaschierten Oberfläche und darauf schaltungsgerecht angeordneten und zum Teil mit weiteren Teilen der metallkaschierten Oberfläche verbundenen Halbleiterbauelementen und vorteilhafterweise weiteren Bauelementen wie z.B. einem Temperatursensor.

Die elektrische Verbindung zwischen den Kontaktflächen, die Teile der metallkaschierten Oberfläche des Substrates sind, und dem Kontaktelement zum Anschluss der zu schaltenden Stromleiter bzw. der Steuereinrichtung wird mittels Anschlusselementen erreicht, die in einem Teilabschnitt federnd ausgeführt sind.

Das Gehäuse besteht aus mehreren formstabilen Teilkörpern, die ihrerseits aus elektrisch isolierendem Kunststoff bestehen. Ein erster Teilkörper weist an seiner Unterseite eine Aussparung zur Aufnahme des Substrates auf. Weiterhin weist er Ausnehmungen und / oder Durchführungen für die Anschlusselemente auf. An seiner Oberseite sind Verbindungselemente, beispielsweise Rastnasen, angeordnet zur Verbindung mit einem weiteren Teilkörper, der seinerseits, beispielsweise auf seiner Oberseite, eine Aussparung für die Steuereinrichtung sowie Durchführungen für die Anschlusselemente zu deren Kontaktierung aufweist. Durch die Verbindung der beiden Teilkörper des Gehäuses werden die Anschluss- und Kontaktelemente in ihrer Lage fixiert.

Das Gehäuse weist weiterhin Ausnehmungen auf zur Verbindung der zu schaltenden Stromleiter mit den ihnen zugeordneten Kontaktelementen sowie zur druckkontaktierenden Befestigung auf einem Grund- oder Kühlkörper.

Die sichere elektrische Kontaktierung aller Anschlusselemente mit den Kontaktflächen des Substrates, den Kontaktelementen und der Steuereinrichtung wird erst durch die Verbindung des Gehäuses mit einem Grund- oder Kühlkörper hergestellt. Hierbei werden die federnd ausgeführten Anschlusselemente mit Druck beaufschlagt und durch ihre Federkraft ergibt sich die sichere elektrische Kontaktierung ebenso wie die thermische Kontaktierung mit dem Grund- oder Kühlkörper.

Der Grundgedanke der Erfindung kann abgewandelt werden, indem mindesten eines in einem Teilbereich federnd ausgestaltetes Anschlusselement mit dem Substrat stoffschlüssig, z.B. mittels Löten, verbunden wird.

Vorteilhaft an dieser Ausgestaltung ist, dass durch die in einem Teilbereich federnde Ausgestaltung die von starren Verbindungen bekannten Probleme zum Beispiel der Dauerhaltbarkeit bei einer Vielzahl von Temperaturwechseln vermieden werden.

Auch bei dieser Ausgestaltung wird die sichere elektrische Kontaktierung aller nicht gelöteter Anschlusselemente mit den Kontaktflächen des Substrates, aller Anschlusselemente mit den Kontaktelementen und der Steuereinrichtung erst durch die Verbindung des Gehäuses mit einem Grund- oder Kühlkörper hergestellt.

Spezielle Ausgestaltungen der erfinderischen Lösungen werden an Hand der Fig. 1 bis 4 erläutert.
- Fig. 1: zeigt ein Substrat eines Halbleiterrelais.
- Fig. 2: zeigt einen ersten Teilkörper eines Gehäuses.
- Fig. 3: zeigt einen weiteren Teilkörper eines Gehäuses.
- Fig. 4: zeigt eine Explosionszeichnung eines erfinderischen Halbleiterrelais.

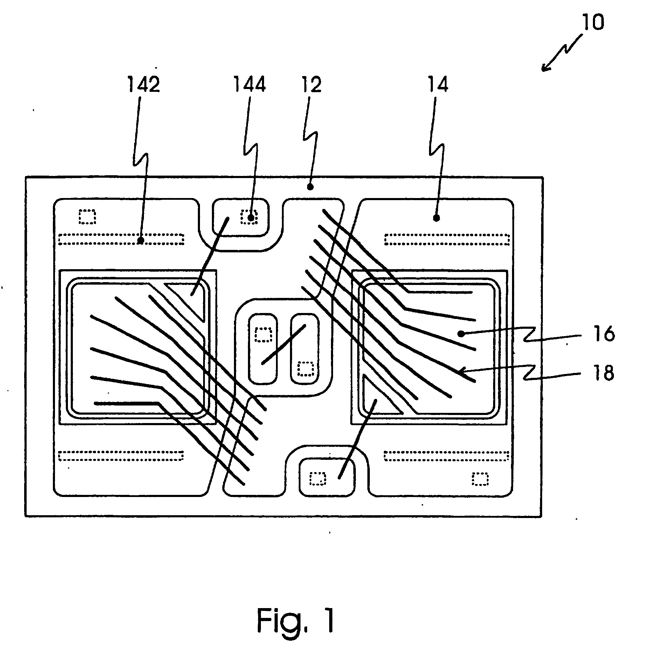

Fig. 1 zeigt ein Substrat (10) eines Halbleiterrelais, bestehend aus einem keramischen Grundkörper (12) aus Aluminiumoxid oder Aluminumnitrit, darauf angeordneten kupferkaschierten Flächen (14). Auf diesen Flächen angeordnet sind die Leistungsschalter, hier zwei antiparallel geschaltete Thyristoren (16). Diese Thyristoren sind mit der ihnen zugeordneten kupferkaschierten Fläche löttechnisch verbunden. Verbindungen mit weiteren kupferkaschierten Flächen werden mittels Drahtbondverbindungen (18) hergestellt. Vorteilhafterweise sind auf dem Substrat weitere Flächen vorgesehen zur Aufnahme von z.B. Sensoren, wie einem Temperatursensör zur Überwachung der Temperatur der Leistungsschalter. Auf den kupferkaschierten Flächen (14) sind Bereiche (142, 144) freigehalten zur elektrisch leitenden Verbindung mittels im weiteren zu beschreibenden Anschlusselementen. Die Bereiche (142) dienen als Kontaktstellen für die Leistungsanschlusselemente, die Bereiche (144) als Kontaktstellen für die Hilfsanschlusselemente, wie beispielsweise die Gateansteuerung des Thyristors (16) oder zum Abgriff der Sensordaten. Vorteilhafterweise ist die Rückseite des Substrates ebenfalls mit einer meist vollflächigen Kupferkaschierung versehen.

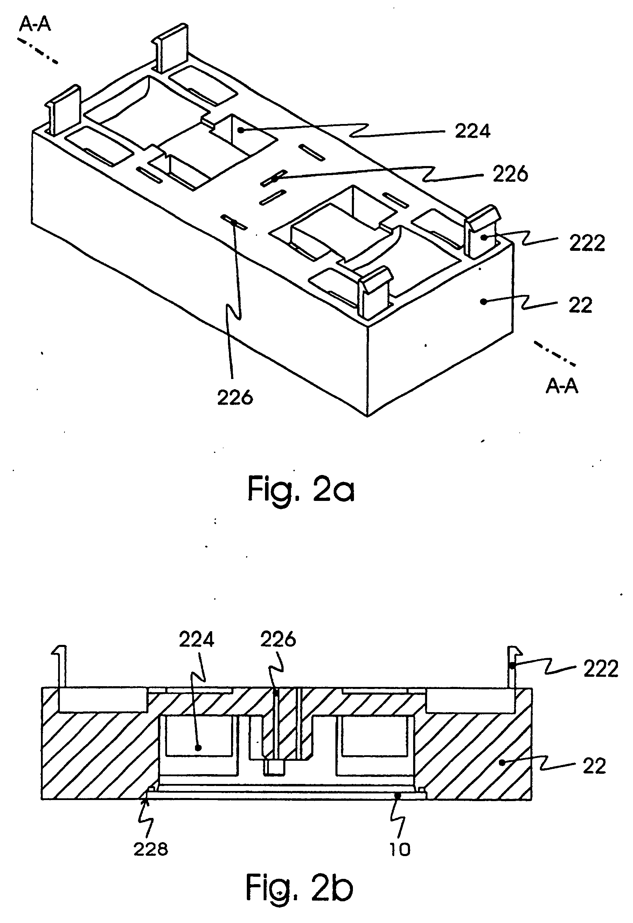

Fig. 2 zeigt einen ersten Teilkörper (22) eines Gehäuses sowohl in dreidimensionaler Darstellung (Fig. 2a) als auch im Längsschnitt (Fig. 2b) durch die Mitte des Teilkörpers entlang der Linie A-A. Dieser erste Teilkörper weist an seiner Unterseite eine Aussparung (228) zur Aufnahme des Substrates (10) auf. Das Substrat ist mittels eines adhärenten Werkstoffes, der gleichzeitig auch im Inneren des Teilkörpers auf der Oberfläche des Substrates aufgebracht sein kann und dort der elektrischen Isolierung der Bauelemente dient, an dem Teilkörper fixiert. Als geeigneter Werkstoff hat sich hierfür Silikonkautschuk herausgestellt. Der Teilkörper (22) weist weiterhin Durchführungen und / oder Ausnehmungen (224, 226) auf, die der Aufnahme von metallischen Anschlusselementen (34, 36) sowie von Kontaktelementen (40), siehe weiter unten, dienen. Die mit Durchführungen versehenen Ausnehmungen (224) sind derart angeordnet, dass sich die Durchführungen direkt in der Fortsetzung einer gedachten Senkrechten ausgehend von den Kontaktstellen (142) für die Leistungsanschlusselemente auf dem Substrat (10) befinden. Die Durchführungen (226) sind in gleicher Weise oberhalb der Kontaktstellen (144) der Hilfsanschlüsse des Substrates (10) angeordnet.

Der erste Teilkörper (22) weist auf seiner Oberseite weiterhin vier Rastnasen (222) zur Verbindung mit einem weiteren Teilkörper (24) auf, wobei diese Rastnasen in entsprechenden Widerlagem des weiteren Teilkörpers einrasten.

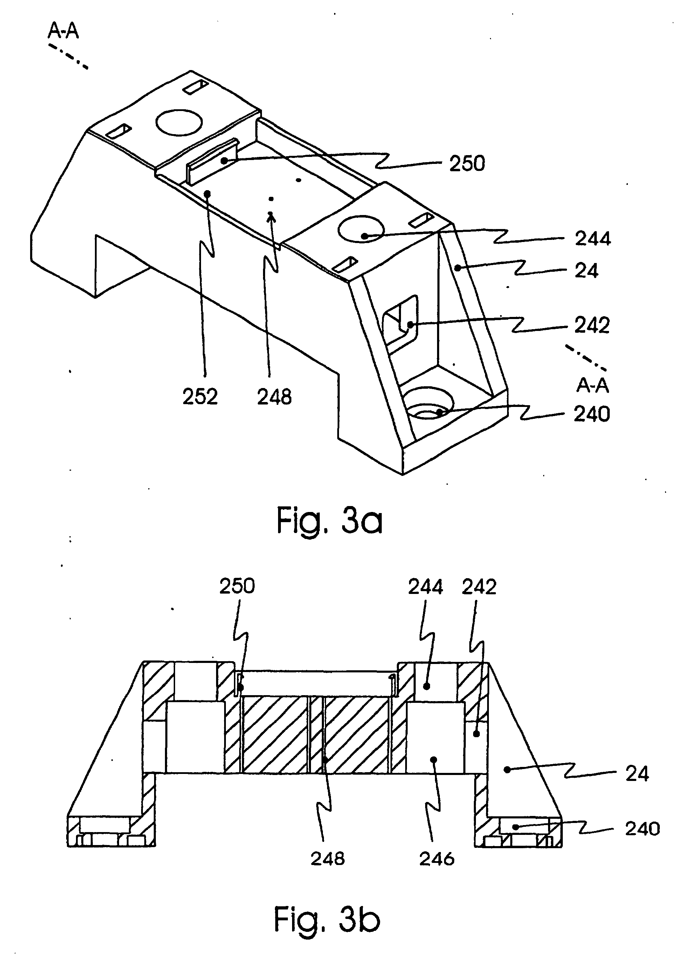

Fig. 3 zeigt einen weiteren Teilkörper (24) eines Gehäuses sowohl in dreidimensionaler Darstellung (Fig.3a) als auch als Längsschnitt (Fig. 3b) durch die Mitte des Teilkörpers entlang der Linie A-A. Dieser weitere Teilkörper weist an seiner Oberseite eine Aussparung (252) zur Aufnahme einer Steuereinrichtung (50), siehe weiter unten, auf. Die Rastnasen (250) dienen der Befestigung dieser Steuereinheit (50) in der Aussparung (252).

Der Teilkörper (24) weist weiterhin Durchführungen und / oder Ausnehmungen (246, 248) auf, die der Aufnahme von metallischen Anschlusselementen (34, 36) sowie von Kontaktelementen (40), siehe weiter unten, dienen. Die Durchführungen (248) sind derart angeordnet, dass sie sich direkt in der Fortsetzung der Durchführungen (226) des ersten Teilkörpers (22) befinden und in der Aussparung (252) enden. Die Ausnehmung (246) dient der Aufnahme von Kontaktelementen (40), die Ausnehmung (242) zur Zuführung eines Stromleiters zum Anschlusselement sowie die Ausnehmung (244) zur Bedienung der Kontaktelemente.

Die Ausnehmungen (240) dienen der Befestigung des Gehäuses auf einem Grund- oder Kühlkörper und damit der Druckeinleitung in das Gehäuse nach dem Zusammenbau des ersten und des weiteren Teilkörpers. Bei diesem Zusammenbau rasten die Rastnasen (222) des ersten Teilkörpers in entsprechend angeordnete Widerlager des weiteren Teilkörpers.

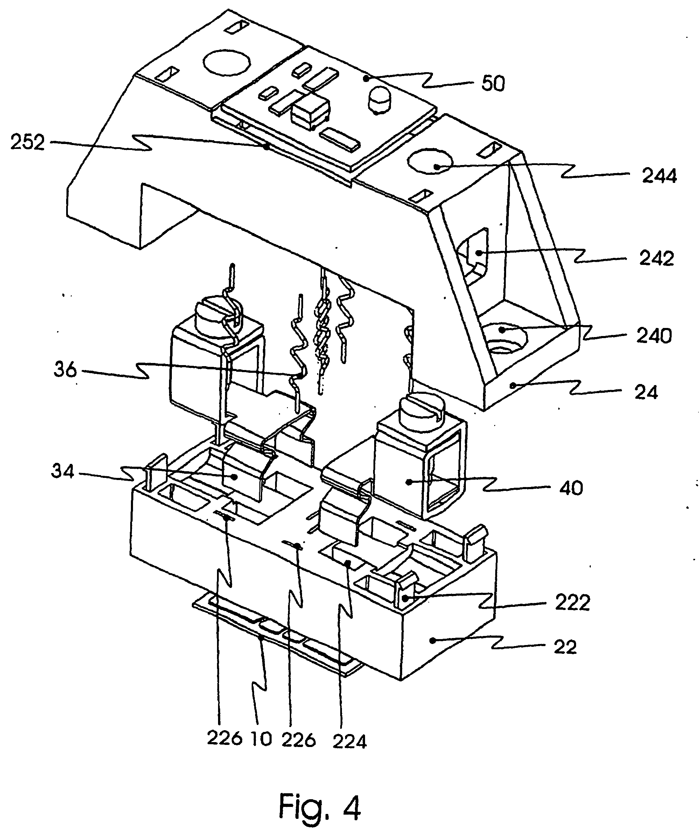

Fig. 4 zeigt eine Explosionszeichnung eines Halbleiterrelais sowie seine wichtigsten Komponenten. Das Halbleiterrelais besteht aus dem Substrat (10), dem ersten Teilkörper (22) des Gehäuses, federnd ausgeführten Leistungs- (34) und Hilfsanschlusselementen (36), Kontaktelementen (40), einem weiteren Teilkörper (24) des Gehäuses sowie einer Steuereinrichtung (50). Das Gehäuse, sowie das Substrat wurden bereits anhand der Fig. 1 bis 3 ausführlich beschrieben.

Zur Ansteuerung eines Halbleiterrelais ist eine Steuereinrichtung (50) unverzichtbar, da sie die als Kleinsignal vorliegenden Steuerbefehle in Ansteuerimpulse für die Halbleiterschalter (16) umsetzt. Diese Steuereinrichtung kann noch weitere Aufgaben, wie z.B. die Temperaturüberwachung der Halbleiterschalter durchführen. Für diese Ansteuerung bzw. Überwachung müssen elektrisch leitende Verbindungen zwischen der Steuereinrichtung (50) und dem Substrat (10) bestehen. Hierfür dienen die in einem Teilabschnitt federnd ausgeführten Hilfsanschlusselemente (36). Diese Hilfsanschlusselemente reichen von dem Substrat (10) bzw. den dort vorgesehenen Kontaktflächen (144) bis zur Rückseite der Steuereinrichtung (50). Geführt werden diese Hilfsanschlusselemente durch die Durchführungen (226 bzw. 252) des ersten (22) bzw. weiteren (24) Teilkörpers des Gehäuses.

Zur Verbindung der externen Stromleiter mit den Halbleiterschaltem weist das Halbleiterrelais Kontaktelemente (40) sowie diese mit dem Substrat verbindenden Leistungsanschlusselemente (34) auf. Die Kontaktelemente sind als Klemmen nach dem Stand der Technik ausgeführt, mit einer Klemmschraube zur sicheren elektrischen Kontaktierung. Das Gehäuse weist hierzu Ausnehmungen (242, 244) auf. Durch die Ausnehmungen (242) werden die Stromleiter zugeführt und mittels der Klemmschrauben, die durch die Ausnehmungen (244) bedient werden, in den Kontaktelementen (40) befestigt.

Die elektrisch leitende Verbindung zwischen den Kontaktelementen (40) und den auf dem Substrat (10) angeordneten Halbleiterschaltern (16) wird mittels der in einem Teilabschnitt federnd ausgestalteten Leistungsanschlusselemente (34) hergestellt. Dazu wird eine Lasche des Leistungsanschlusselements zusammen mit der Stromleitung in dem Kontaktelement (40) mittels der zugehörigen Klemmschraube befestigt. Der Kontakt mit dem jeweiligen Halbleiterschalter wird mittels zweier federnd ausgeführter Laschen des Leistungsanschlusselementes sowie der Kontaktstellen (142) des Substrates hergestellt.

Die Montage des Halbleiterbauelements beginnt mit der adhärenten Verbindung des Substrates (10) mit dem ersten Teilkörper (22) des Gehäuses. Hierbei wird keine starre, sondern eine elastische Verbindung dieser beiden Teile geschaffen, die ausschließlich einer Fixierung dient. Als Werkstoff für diese Verbindung eignet sich beispielhaft ein elastischer Silikonkautschuk.

Anschließend wird der erste Teilkörper (22) des Gehäuses mit den Hilfs- (36), den Leistungsanschlusselementen (34) und den Kontaktelementen (40) bestückt. Diese werden in den jeweils hierfür vorgesehenen Durchführungen bzw. Aussparungen (224, 226) angeordnet. Die Leistungsanschlusselemente (34) können zusätzlich mit den Kontaktstellen (142) z.B. mittels eine Induktionslötverfahrenens miteinander stoffschlüssig verbunden werden. Ein Verguss der Bauelemente (16) des Substrates mit einem elastischen elektrisch isolierenden Werkstoff, vorzugsweise einem Silikonkautschuk, ähnlich oder identisch demjenigen zur Verbindung des Substrates mit dem ersten Teilkörper des Gehäuses ist in der Regel ein notwendiger weiterer Arbeitsgang.

Durch die Verbindung des ersten (22) mit dem weiteren (24) Teilkörper des Gehäuses mittels Rastnasen (222) und deren Widerlager werden die Anschlusselemente (34, 36) und das Kontaktelement (40) in ihrer Lage fixiert. Nach dem Befestigen der Steuereinheit (50) mittels der Rastnasen (250) ist die Montage des Halbleiterrelais abgeschlossen. Auf Grund dieser einfachen Fertigungsschritte ist das Halbleiterrelais einer automatisierten Fertigung leicht zugänglich. In diesem Fertigungszustand bestehen ohne die o.g. optionale Lötverbindung allerdings noch keine sicheren elektrischen Verbindungen zwischen dem Substrat und den Kontaktelementen bzw. der Steuereinheit.

Eine sichere elektrische Verbindung aller Kontaktstellen wird erst durch die druckeinleitende Montage auf einem Grund- oder Kühlkörper gewährleistet. Mittels durch die Ausnehmungen (240) geführter Schrauben wird das Halbleiterrelais auf einem Grund- oder Kühlkörper befestigt. Dabei wird über das Gehäuse ein Druck eingeleitet, der einerseits eine sichere thermische Kontaktierung des Substrates auf den Grund- oder Kühlkörper bewirkt, andererseits die Leistungsanschlusselemente derart mit Druck beaufschlagt, dass eine sichere elektrische Kontaktierung dieser mit dem Substrat erreicht wird. Hierzu ist die federnde Ausgestaltung in einem Teilabschnitt der Leistungsanschlusselemente notwendige Voraussetzung. Diese gestattet eine gleichbleibende Andruckstärke auf den Kontaktflächen (142) unabhängig von der thermischen Ausdehnung des Gehäuses oder anderer dies beeinflussender Effekte über die gesamte Lebenszeit des Halbleiterrelais.

Bei bereits montierter Steuereinheit werden durch die Befestigung des Gehäuses auf dem Grund- oder Kühlkörper die Hilfsanschlusselemente (36) ebenfalls mit Druck beaufschlagt. Durch ihre in einem Teilabschnitt federnde Ausgestaltung wird somit eine sichere elektrische Kontaktierung zwischen den Kontaktflächen (144) des Substrates und der Steuereinheit erreicht. Die federnde Ausgestaltung in Kombination mit der Druckkontaktierung führt zu einer über die Lebensdauer des Halbleiterrelais sicheren und auf Grund gleichbleibender Druckkräfte, qualitativ gleichbleibenden Kontaktierung.

## Patentansprüche

1. Halbleiterrelais bestehend aus einem keramischen Substrat (10) mit einer strukturierten metallkaschierten Oberfläche (14), darauf schaltungsgerecht angeordneten Halbleiterbauelementen (16), einem mehrteiligen Gehäuse (22, 24) mit Ausnehmungen (240) zur Befestigung auf einem Grund- oder Kühlkörper, von Kontaktflächen (142) des Substrats (10) zu Kontaktelementen (40) führenden Leistungsanschlusselementen (34), von weiteren Kontaktflächen (144) des Substrats zu einer Steuereinrichtung (50) führenden Hilfsanschlusselementen (36), wobei diese Anschlusselemente (34, 36) in einem Teilabschnitt federnd ausgeführt sind, diese Anschlusselemente (34, 36) durch Durchführungen und / oder Ausnehmungen (224, 226) des ersten (22) und / oder weiteren (24) Teilkörpers des Gehäuses mit dem Substrat (10) kontaktiert sind und diese Anschlusselemente (34, 36) sowie die Kontaktelemente (40) durch ein erstes (22) und ein weiteres (24) mittels einer Schnappverbindung (222) miteinander verbundenes Gehäuseteil in ihrer Lage fixiert sind.

2. Halbleiterrelais nach Anspruch 1, wobei die Steuereinrichtung (50) mittels Rastnasen (250) in einer Aussparung (252) des weiteren Gehäuseteils (24) befestigt ist.

3. Halbleiterrelais nach Anspruch 1, wobei das Substrat (10) mittels eines adhärenten Werkstoffes in einer Aussparung (228) des ersten Teilkörper (22) des Gehäuses fixiert ist.

4. Halbleiterrelais nach Anspruch 3, wobei der adhärente Werkstoff ein Silikonkautschuk ist, der auch die Halbleiterbauelemente (16) elektrisch von einander isoliert.

5. Halbleiterrelais nach Anspruch 1, wobei die Leistungsanschlusselemente (34) stoffschlüssig mit den Kontaktflächen (142) des Substrates (10) verbunden sind.

6. Halbleiterrelais nach Anspruch 1, wobei das Substrat (10) aus Aluminiumoxid oder Aluminiumnitrit besteht

7. Halbleiterrelais nach Anspruch 1, wobei die Halbleiterbauelemente Thyristoren und Sensoren sind.

8. Halbleiterrelais nach Anspruch 1, wobei die Halbleiterbauelemente stoffschlüssig mit der Metallkaschierung (14) des Substrates (10) verbunden sind und zumindest zum Teil Drahtbondverbindungen (18) zu anderen Metallkaschierungen aufweisen.

## Claims

1. A semiconductor relay comprising a ceramic substrate (10) having a structured, metal-laminated surface (14), semiconductor components (16) positioned thereon correctly for the circuit, a multipart housing (22, 24) having recesses (240) for attachment to a base or cooling body, power connection elements (34) leading from contact areas (142) of the substrate (10) to contact elements (40), and auxiliary connection elements (36) leading from further contact areas (144) of the substrate to a control unit (50),
wherein these connection elements (34, 36) are implemented as springy in one section, these connection elements (34, 36) are in contact with the substrate (10) through bushings and/or recesses (224, 226) of the first (22) and/or further (24) partial body of the housing, and these connection elements (34, 36) and the contact elements (40) are fixed in their position by a first (22) and a further (24) part of the housing, connected to one another using a snap connection (222).

2. The semiconductor relay according to Claim 1,
wherein the control unit (50) is attached in a recess (252) of the further housing part (24) using catch lugs (250).

3. The semiconductor relay according to Claim 1,
wherein the substrate (10) is fixed in a recess (228) of the first partial body (22) of the housing using an adhesive material.

4. The semiconductor relay according to Claim 3,
wherein the adhesive material is a silicone rubber which also electrically insulates the semiconductor components (16) from one another.

5. The semiconductor relay according to Claim 1,
wherein the power connection elements (34) are integrally joined to the contact areas (142) of the substrate (10).

6. The semiconductor relay according to Claim 1,
wherein the substrate (10) is made of aluminum oxide or aluminum nitrite.

7. The semiconductor relay according to Claim 1,
wherein the semiconductor components are thyristors and sensors.

8. The semiconductor relay according to Claim 1,
wherein the semiconductor components are integrally joined to the metal lamination (14) of the substrate (10) and at least partially have wire bond connections (18) to other metal laminations.

## Revendications

1. Relais semi-conducteur constitué des éléments suivants : un substrat céramique (10) comportant une surface métallisée structurée (14) ; des composants semi-conducteurs (16) disposés dessus de manière à former un circuit ; un boîtier (22, 24) en plusieurs parties comportant des trous (240) permettant une fixation sur un corps de base ou sur un dissipateur de chaleur ; des éléments de raccordement de puissance (34) allant de surfaces de contact (142) du substrat (10) jusqu'à des éléments de contact (40) ; des éléments de raccordement auxiliaires (36) allant d'autres surfaces de contact (144) du substrat jusqu'à un dispositif de commande (50) ; lesdits éléments de raccordement (34, 36) étant réalisés de manière souple dans une section, ces éléments de raccordement (34, 36) étant mis en contact avec le substrat (10) par des passages et/ou des trous (224, 226) ménagés dans la première (22) et/ou l'autre (24) partie du boîtier, et la position desdits éléments de raccordement (34, 36) ainsi que celle des éléments de contact (40) étant fixées par une première (22) et une autre (24) pièces de boîtier reliées ensemble au moyen d'un assemblage à enclenchement (222).

2. Relais semi-conducteur selon la revendication 1, dans lequel le dispositif de commande (50) est fixé dans un évidement (252) de l'autre pièce de boîtier (24) au moyen de saillies d'encliquetage (250).

3. Relais semi-conducteur selon la revendication 1, dans lequel le substrat (10) est fixé dans un évidement (228) de la première partie (22) du boîtier au moyen d'une matière adhésive.

4. Relais semi-conducteur selon la revendication 3, dans lequel la matière adhésive est un caoutchouc silicone qui a également pour effet d'isoler électriquement les uns des autres les composants semi-conducteurs (16).

5. Relais semi-conducteur selon la revendication 1, dans lequel les éléments de raccordement de puissance (34) sont reliés par liaison de matière aux surfaces de contact (142) du substrat (10).

6. Relais semi-conducteur selon la revendication 1, dans lequel le substrat (10) est fait d'oxyde d'aluminium ou de nitrite d'aluminium.

7. Relais semi-conducteur selon la revendication 1, dans lequel les composants semi-conducteurs sont des thyristors et des capteurs.

8. Relais semi-conducteur selon la revendication 1, dans lequel les composants semi-conducteurs sont reliés par liaison de matière à la métallisation (14) du substrat (10) et comportent, au moins en partie, des connexions par fil (18) vers d'autres métallisations.
